Europäisches Patentamt

European Patent Office

Office européen des brevets

(11) Publication number: **0 513 522 A2**

# EUROPEAN PATENT APPLICATION

(21) Application number: **92105955.6**

(22) Date of filing: **07.04.92**

(51) Int. Cl.5: **H05K 3/34**

(30) Priority: **09.05.91 IT MI911268**

(43) Date of publication of application:
**19.11.92 Bulletin 92/47**

(84) Designated Contracting States:
**DE FR GB NL**

(71) Applicant: **Castoldi, Aldo**
**Via Londonio, 31**
**I-20154 Milano(IT)**
Applicant: **Gullo, Manuela**
**Via Londonio, 31**
**I-20154 Milano(IT)**

(72) Inventor: **Castoldi, Aldo**
**Via Londonio, 31**
**I-20154 Milano(IT)**

(74) Representative: **Dr. Ing. A. Racheli & C.**
**Viale San Michele del Carso, 4**
**I-20144 Milano(IT)**

(54) **Process and apparatus for welding components on printed circuit plates by means of a solder bath.**

(57) A process and related apparatus for welding the components on printed circuit plates by means of a bath of solder in the melted state, using wave, weir, vibration, static techniques etc., comprising in succession the following phases: fluxing (2), pre-heating (3), at least one washing (4, 5), the possible replacement of solvents (6), additional fluxing (7), possible pre-heating (8), welding (9) and possible mild washing (10), in which the phases from (4) to (8) are carried out in a controlled atmosphere or in a vacuum.

FIG. 2

The present invention concerns a process and a related apparatus for welding the components on printed circuit plates by means of a bath of solder in the melted state.

There are in existence different methods of welding electronic components, whether integrated or not, on related printed circuits. The one referred to by the present invention is carried out by means of solder which is maintained in the melted state and uses wave, weir, vibration, static welders etc..

This known method of welding consists at the moment of the following phases:
- fluxing of the parts which are to be welded;
- pre-heating of the fluxed parts;
- contact with the solder;
- cooling;
- possible washing of the plate complete with components.

The use of this welding cycle involves various drawbacks, which will be easier to understand from some preliminary necessary considerations, which are listed below.

A) Fluxing is a necessary operation since, if the surface oxides of the metals which are to be welded are not removed, welding does not take place or takes place in an unreliable fashion (no formation of intrametallic layers, cold weldings, welding bridgings etc.). The action of pre-heating is to increase the pickling action of the fluxant.

B) Since the fluxants are chemical reagents which are corrosive to a greater or lesser degree, the residue remaining after welding is an undesirable aspect, as it could give rise to corrosive action which could take place with the passage of time and under certain environmental conditions.

C) As a direct consequence of the previous point, it is desirable for the fluxants to have the following characteristics:
- they should be activated only at the moment when they are needed (in the welding phase), and then they should return to being completely inert;
- they should be able to act in the smallest concentrations;
- preferably they should disappear without leaving any trace immediately after welding.

Since no type of fluxant is in existence which possesses all the above listed characteristics, the need has arisen, in the case of high-reliability printed circuits, to subject the plates to washing after the welding process.

At this point, the users can be divided into different categories, according to whether or not they accept certain operative choices:

1) Some accept only washing with aqueous solutions. This means that the fluxants which are chosen must be of the water-soluble type, thus limiting the group of fluxants which can be employed.

2) Others accept only washing with organic solvents (alcohols, chlorines and so on). As in the previous case, the fluxants must be able to be removed by such solvents, and therefore there is another limitation on which fluxants can be used.

3) In conclusion, as for example in the case of professional-type printed circuits for military uses, there are those who do not want any type of washing, since the only type of fluxant allowed is the type with a non-activated colophony base only, and which is therefore absolutely inert even under the most detrimental environmental conditions.

The solution to the problems described above in points 1) and 2) is based on the use of strongly detergent washing solutions, containing formulas with a certain degree of complexity, which must remove the welding residues by making use of their intrinsic high alkalinity. The consequence of this is that the operation is laborious to carry out, as it involves both a forced rinsing phase to remove every trace of electrolytes and a subsequent treatment of the dirty and exhaust solutions so that they can be eliminated.

The conditions described in point 3) place severe restrictions also as far as the metals which can be used are concerned: in fact, only a certain number of them can be pickled to a fair extent with activated colophony alone, since the corrosive power of this substance is weak.

It can therefore be stated that the known processes of welding with a solder bath fall under the following extreme positions: they either make use of fluxants which are highly corrosive, and for this reason can be used in quite low concentrations (but whose residues after welding can involve great risks), or they make use of fluxants with a low corrosive action, which however must be used in quite high concentrations, in order to be able to carry out the necessary pickling action. In the latter case, the residues after welding are usually very noticeable.

These technical solutions, however, always involve environmental pollution during the welding phase, which cannot be ignored, since the fluxants undergo heat degradation and emit fumes, which are often very thick and the qualitative composition of which is not always known, but which, nevertheless, must be intercepted and removed in the interests of suitably hygienic conditions in work places.

In the same way, or to an even greater extent, the above holds good for the whole series of fluxants which are designed to volatilize and disappear during the welding phase itself.

The aim of the present invention is to eliminate the above mentioned disadvantages, by providing a process and the related apparatus for welding electronic components on printed circuits, with a solder bath technique (with wave, weir, vibration, static techniques etc.), which will allow the use of any type of fluxant whatsoever, and which will eliminate any risk of imperfect welding.

The process according to the present invention comprises in succesion the phases given below:
- fluxing of the parts to be welded;
- possible pre-heating of the fluxed parts;
- at least one washing of the fluxed parts in a controlled atmosphere;
- fluxing with a fluxant with a low corrosive action and at a low concentration, again in a controlled atmosphere;
- possible pre-heating or drying in a controlled atmosphere;
- welding;
- possible mild washing.

The controlled atmosphere in which some of the phases of the described process are carried out acts to keep the working environment away from contact with the air and corrosive gases, and it can be achieved by means of inert gases, rare gases, nitrogen, etc., or also by means of a vacuum.

Between the fluxing and washing phases carried out in a controlled atmosphere, a unit can be foreseen for replacing the solvents (for example non-alcoholic with alcoholic), in order to eliminate any possible incompatibility between the solvents used in the two fluxing stages.

Further characteristics and advantages of the present invention will be made clearer by the detailed description given below, which refers to a non-restrictive embodiment of the same, with reference to the appended drawings, in which:

Figure 1    is a block diagram illustrating the phases of a traditional welding process;

Figure 2    is a block diagram illustrating the welding process according to the present invention.

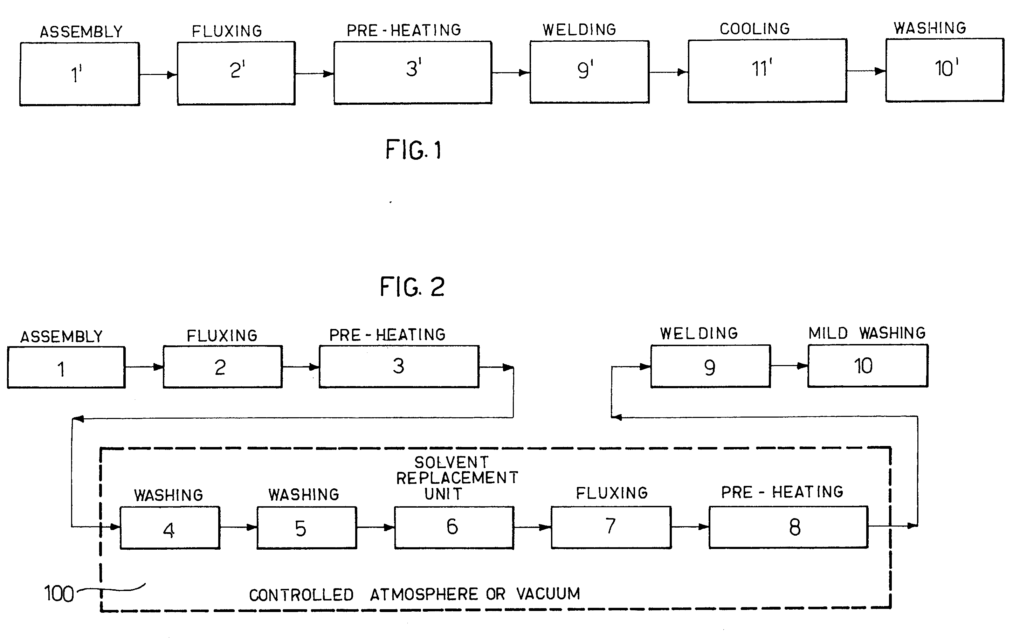

A traditional welding process of the components for printed circuits by means of the on-line use of automatic machines, making use of solder baths in the melted state, with wave, weir, vibration, static techniques etc., comprises, as in shown in diagrammatic form in figure 1, the assembling, fluxing, pre-heating, welding, cooling and washing phases, shown in the units with the numbers 1', 2', 3', 9', 11' and 10' respectively. These reference numbers will be used unprimed to indicate corresponding units of the apparatus for carrying out the procedure according to the invention, which is shown in figure 2.

The traditional welding process illustrated in figure 1 has the previously illustrated disadvantages, which tend to be eliminated by the present invention.

According to the present invention, a series of phases, which are carried out in a controlled atmosphere or in a vacuum, are foreseen between the pre-heating unit 3 and the welding unit 9, as is illustrated in diagrammatic form by the block 100, which is drawn with a dotted line in figure 2.

In particular, at least one washing unit is foreseen (in figure 2 two of these units are shown, indicated respectively with numbers 4 and 5 and carrying cut in series a "rough" and a more precise washing). There are also a possible unit for the replacement of the solvents 6, a fluxing unit 7 with a fluxant with a low corrosive action and at a low concentration (for example of the non-activated colophony type) and a possible pre-heating or drying unit 8.

The welding cycle according to the invention has the following advantages with respect to a corresponding traditional cycle.

A) The finished product according to the invention provides the strongest guarantees of reliability and cleanliness which could be requested. In particular, if the fluxing in a controlled atmosphere at stage 7 has been carried out with a low concentration of colophony solutions, the conditions of the finished product are able to satisfy the requirements of the most stringent quality regulations in the sector (American MIL regulations).

In the fluxing stage 7, in fact, pickling even with non-activated colophony alone is sufficient, since the proper pickling has already been carried out at the fluxing stage 2 in a normal atmosphere. In the unit 6, therefore, the fluxing has only the aim of:

a) completing the removal of traces of passivation formed as a result of the perhaps not high level of purity of the gases used to create the controlled atmosphere (for example nitrogen, argon or others), or solving any accidental leakage in the plant;

b) protecting the previously cleaned surfaces until the time they are welded;

c) preparing the surfaces to be welded in the best conditions for being wetted by the solder.

B) A similar working cycle does not condition beforehand the choice of the fluxant to be used at fluxing stage 2. In fact, any user can continue to use the group of fluxants which he considers most suitable (aqueous, alcoholic, etc.) still attaining, if so desired, the requirements described in point A). Any incompatibility there may be between the solvents of the fluxants used in the fluxing units 2 and 7 can be eliminated by the solvent replacement unit 6.

c) The washing which takes place in stages 4 and 5 is extremely simple, since it is sufficient to use the same type of solvent which is present in the fluxant used in stage 2. The removal, in fact, is very simple since the solid residues of the fluxant have not undergone any degradation or modification, as they have not been subjected to thermal shock from the welding bath.

D) The washing solutions do not need to possess high alkalinity or strong detergent properties, as reported in point C), and in consequence it is much easier to carry out their purification and their subsequent disposal.

E) The washing operations easily create a clean product, as all the fluxed parts are accessible as before, in so far as the welding has not yet been carried out which, as known, at times can conceal the access to certain zones or, at any rate, make them difficult to reach by the washing and rinsing solutions.

F) In the welding phase any cracking fumes which may arise are very greatly reduced, since the solid residues of the fluxant can be kept down to the minimum. This works to the advantage of the hygiene of the working environment and the structure provided for its maintenance.

From what has been explained above, the advantages of the process according to the present invention are easy to see, in comparison with traditional processes.

## Claims

1. A process for welding components on printed circuit plates by means of a bath of solder in the melted state, comprising at least one fluxing phase (2) with a possible pre-heating phase (3) and a welding phase (9) by means of the contact of the parts to be welded with the solder, characterized in that between the said pre-heating phase (3) and the said welding phase (9) at least one washing phase (4, 5) and at least one fluxing phase (7) with a fluxant with a low corrosive action and at a low concentration are foreseen, both in a controlled atmosphere or vacuum.

2. A process according to claim 1, characterized in that the said fluxing phase (7) is followed by a pre-heating or drying phase (8), which is suitable for increasing the pickling action of the corresponding fluxant.

3. A process according to claim 1 or 2, characterized in that between the said at least one washing phase (4, 5) and the said fluxing phase (7) a solvent replacement phase (6) is foreseen, which comes into action in the case of any incompatibility between the solvents of the fluxants which are used in the fluxing stages (2) and (7) respectively.

4. A process according to any one of the previous claims, characterized in that the said welding phase (9) is followed by a mild washing phase (10).

5. A process according to claim 1, characterized in that in the said at least one washing phase (4, 5) the same type of solvent is used as the one present in the fluxant in the fluxing stage (2).

6. A process according to claim 1, characterized in that the said fluxing phase (7) is carried out with non-activated colophony.

7. A process according to any one of the previous claims, characterized in that the said phases in a controlled atmosphere take place with the use of inert gases, rare gases, nitrogen, argon and the like.

8. A process according to any one of the previous claims, characterized in that the said welding phase is carried out with wave, weir, vibration, static techniques and the like.

9. An apparatus for welding components on printed circuit plates by means of a bath of solder in the melted state, with wave, weir, vibration, static techniques and the like, comprising in succession at least one fluxing unit (2), possibly one pre-heating unit (3), one welding unit (9) and a possible washing unit (10), characterized in that between the said pre-heating unit (3) and the said welding unit (9) a controlled atmosphere or vacuum zone is foreseen, which comprises in succession at least one washing unit (4, 5), possibly one solvent replacement unit (6), at least one fluxing unit (7) and possibly a pre-heating unit (8).

10. A printed circuit plate, which comprises a number of electronic, integrated and/or not integrated components welded with the process according to any one of the claims from 1 to 8.

EP 0 513 522 A2

| ASSEMBLY | | FLUXING | | PRE - HEATING | | WELDING | | COOLING | | WASHING |
|:---:|:---:|:---:|:---:|:---:|:---:|:---:|:---:|:---:|:---:|:---:|
| 1' | → | 2' | → | 3' | → | 9' | → | 11' | → | 10' |

## FIG. 1

## FIG. 2

| ASSEMBLY | | FLUXING | | PRE - HEATING | | | WELDING | | MILD WASHING |
|:---:|:---:|:---:|:---:|:---:|:---:|:---:|:---:|:---:|:---:|
| 1 | → | 2 | → | 3 | | | 9 | → | 10 |

| WASHING | | WASHING | | SOLVENT REPLACEMENT UNIT | | FLUXING | | PRE - HEATING |
|:---:|:---:|:---:|:---:|:---:|:---:|:---:|:---:|:---:|
| 4 | → | 5 | → | 6 | → | 7 | → | 8 |

100

CONTROLLED ATMOSPHERE OR VACUUM